# FASCICULE DE BREVET EUROPEEN

(11) **EP 4 069 589 B1**
(45) Date de publication et mention de la délivrance du brevet: **25.03.2026**
(21) Numéro de dépôt: 20812117.8
(22) Date de dépôt: 01.12.2020
(51) Int. Cl.: B64D 45/02, B64D 45/00, G01W 1/02

(54) **DISPOSITIF DE PRÉVENTION DE RISQUES DE PERTURBATIONS ATMOSPHÉRIQUES POUR UN AÉRONEF EN VOL ET AU SOL**
VORRICHTUNG ZUR VERHINDERUNG DES RISIKOS VON ATMOSPHÄRISCHEN STÖRUNGEN FÜR EIN FLUGZEUG IN DER LUFT UND AM BODEN
DEVICE FOR PREVENTING RISK OF ATMOSPHERIC DISTURBANCE FOR AN AIRCRAFT IN THE AIR AND ON THE GROUND

(30) Priorité: 05.12.2019 FR 1913801
(43) Date de publication de la demande: 12.10.2022
(73) Titulaire: SAFRAN ELECTRONICS & DEFENSE, 75015 Paris (FR)
(72) Inventeur: MELCHOR, Vincent, 77550 Moissy-Cramayel (FR)
(74) Mandataire: Casalonga
(86) Numéro de dépôt international: PCT/EP2020/084121
(87) Numéro de publication internationale: WO 2021/110674

(56) Documents cités:
- FR-A1- 3 051 442
- US-A1- 2008 122 424
- US-A1- 2009 234 583
- US-A1- 2019 049 500
- US-B1- 6 246 367

## Description

La présente invention concerne les aéronefs et se rapporte plus particulièrement à la sécurité des passagers à bord d'aéronefs.

La densification du trafic conduit les constructeurs aéronautiques à construire des avions plus légers pour réduire leur consommation d'énergie et de transporter plus de passagers.

Afin de satisfaire ces besoins tout en respectant les normes de sécurité, les constructeurs aéronautiques choisissent d'utiliser des matériaux légers par exemple à base de fibres de carbone.

De plus, avec les exigences de rentabilité et les impératifs d'horaires pour les vols commerciaux, il devient de plus en plus difficile d'éviter des perturbations atmosphériques tant au sol, particulièrement pendant les phases de rechargement, qu'ne vol.

Par « perturbations atmosphériques » on entend tout perturbateur pouvant avoir des effets néfastes sur l'intégrité des équipements. On peut citer par exemple des rayonnements électromagnétiques issus d'un foudroiement, des rayonnements cosmiques ou ionisants.

Ainsi, ces perturbations atmosphériques peuvent mettre la sécurité des passagers à bord de l'aéronef en danger. En effet, la foudre frappe un aéronef en moyenne deux fois par an, ce qui peut détruire les composants électroniques à bord ou conduire à un fonctionnement aléatoire.

Même si on essaie de les éviter, la récolte d'informations sur les risques d'exposition à ces perturbations ne peuvent s'effectuer en plein vol. Il est donc difficile de prédire le niveau de risque pendant le vol.

Afin de diminuer ce risque, on protège systématiquement tous les composants électroniques de l'aéronef, ce qui ne permet pas de faire un réel gain de masse.

Dans certains types d'avions commerciaux, par exemple, la masse des composants électroniques destinés au filtrage représente approximativement 500 Kg.

De plus, afin de protéger ces composants, des diodes de suppression de tensions transitoires (« transient voltage suppressor » en anglais) sont utilisées et multiplient par conséquent la masse par deux.

Cette importante masse est due à l'utilisation des matériaux composites. En effet, les formes d'ondes induites sur les câbles sont plus énergétiques que sur des aéronefs en aluminium.

Dans ces conditions, il devient difficile de répondre simultanément aux exigences économiques tout en préservant la sécurité des passagers.

Il existe donc un besoin d'utiliser un système automatisé apte à limiter les risques d'exposition de l'aéronef en vol et au sol en fonction de l'environnement dans lequel il évolue.

Cela conduit plus particulièrement à une réduction de la masse des composants électroniques à bord de l'aéronef. US 2019049500 A1 montre un système permettant de déterminer le risque pour un avion d'être frappé par une foudre. Une antenne est utilisée pour déterminer l'accumulation de charge statique sur le fuselage de l'avion.

Au vu de ce qui précède, l'invention se propose de pallier les contraintes précitées en proposant un dispositif de prévention de risques de perturbations atmosphériques pour un aéronef en vol ou au sol en fonction du trajet emprunté et des conditions atmosphériques autour dudit aéronef.

Selon l'invention, il est prévu un procédé de prévention en temps réel de risques de perturbations atmosphériques pour un aéronef en vol ou au sol tel que défini dans la revendication 1. Le procédé comprend au moins une acquisition par l'aéronef de données correspondant auxdits risques.

Selon l'invention, le procédé comprend en outre une élaboration, à partir desdites données, d'une carte prédictive d'au moins une zone critique correspondant à au moins un niveau de risque de perturbation déterminé, et une mise en œuvre d'une protection de composants électroniques à bord de l'aéronef susceptibles d'être endommagés si ladite au moins une zone critique est traversée par l'aéronef.

En d'autres termes, on définit pour chaque type de perturbation, un indice de risque spécifique qui permet d'optimiser la mise en œuvre de la protection des composants électroniques, si la valeur de l'indice de risque est suffisamment élevée pour qualifier la zone comprenant cette perturbation, de zone critique.

Ainsi, en fonction du type de la perturbation atmosphérique, on peut protéger les composants susceptibles d'être endommagés si l'aéronef est amené à être particulièrement exposé à ce type de perturbation, par exemple le foudroiement.

Selon l'invention, ladite au moins une acquisition comprend une mesure par l'aéronef du champ électrique, du champ magnétique, des ondes électriques et magnétiques radio, et une réception à distance de données de mesure du champ électrique et du champ magnétique, des ondes électriques et des ondes magnétiques radio, réalisés par au moins deux autres aéronefs en vol ou au sol et/ou des stations au sol.

Les ondes magnétiques radio, préférentiellement des ondes moyennes ayant une fréquence entre 10 et 150 kHz, permettent de détecter à longue distance les arcs électriques.

Le champ électrique proche permet particulièrement de déterminer s'il y a un risque de foudroiement en champ proche, contrairement aux ondes électriques radio qui autorisent une détection longue distance.

Il est à noter que le déphasage entre les champs électrique et magnétique permet de déterminer, en le corrélant avec l'heure de la réalisation des deux mesures, la position de la perturbation atmosphérique.

Préférentiellement, le procédé comprend un stockage à distance en temps réel des données acquises.

Chaque aéronef peut ainsi partager sa position et les données relatives aux risques de perturbations atmosphériques, et ainsi élaborer une carte plus précise.

Les données partagées peuvent être corrélées avec des informations issues des stations au sol.

Avantageusement, l'élaboration de la carte prédictive comprend une mise en œuvre d'au moins une machine d'apprentissage automatique supervisé ou non supervisé.

L'utilisation d'une machine d'apprentissage automatique (« deep learning machine » en anglais) permet de trier efficacement les données partagées par les aéronefs en vol ou au sol, et les stations au sol, et ainsi élaborer un indice de risque spécifique à chaque risque de perturbation atmosphérique en fonction du trajet emprunté par l'aéronef.

De préférence, la mise en œuvre de la protection des composants électroniques comprend une désactivation desdits composants et/ou une activation de moyens d'isolation desdits composants.

Afin de limiter les risques de destruction ou de fonctionnement aléatoire de composants électroniques, il est avantageux de graduer le niveau de sensibilité desdits composants en fonction du niveau de risque de la perturbation détectée et ainsi choisir de désactiver, isoler ou maintenir le fonctionnement de ces composants.

Préférentiellement, les perturbations atmosphériques comprennent le foudroiement et/ou une exposition à des rayons cosmiques et/ou ionisants.

On peut citer par exemple une exposition aux rayons Gamma et/ou Alpha et/ou Beta et/ou X.

Selon l'invention il est proposé un dispositif de prévention en temps réel de risques de perturbations atmosphériques pour un aéronef en vol ou au sol tel que défini dans la revendication 6 comprenant des moyens d'acquisition aptes à acquérir des données correspondant auxdits risques.

Il comporte également des moyens de conception aptes à élaborer une carte prédictive d'au moins une zone critique correspondant à au moins un niveau de risque de perturbation déterminé, et des moyens de protection de composants électroniques à bord de l'aéronef susceptibles d'être endommagés si ladite au moins une zone critique est traversée par l'aéronef.

Selon l'invention, les moyens d'acquisition comprennent des moyens de mesure aptes à mesurer le champ électrique, le champ magnétique, les ondes électriques et les ondes magnétiques radio, et des moyens de télécommunication aptes à recevoir les données de mesure du champ électrique, du champ magnétique, et des ondes magnétiques et des ondes électriques radio, ces mesures étant réalisées par au moins deux autres aéronefs en vol ou au sol et/ou des stations au sol.

On peut citer comme moyen de télécommunication, les constellations de satellites en orbite basse telle qu'Iridium^{®} et Starlink^{®}, des nanosatellites de type CubeSat^{®} ou des radios VHF (pour « Very High Frequency » selon le vocable anglosaxon) ou UHF (« Ultra High Frequency » en anglais).

Préférentiellement, les moyens d'acquisition comportent au moins un capteur électro-optique apte à mesurer le champ électrique et le champ magnétique périphérique proche.

Avantageusement, le dispositif comprend des moyens de stockage à distance en temps réel des données acquises.

Les données recueillies par l'aéronef en vol ou au sol peuvent être redirigées vers un serveur informatique distant apte à stocker lesdites données et les exploiter.

Préférentiellement, les moyens de conception comprennent au moins une machine d'apprentissage automatique supervisé ou non supervisé.

De préférence, les moyens de protection comprennent des moyens d'isolation, les moyens de protection étant aptes à désactiver lesdits composants et/ou à activer les moyens d'isolation desdits composants.

Certains composants électroniques, généralement utilisés dans des architectures intelligentes et/ou de commutation, sont particulièrement sensibles comme par exemple les SSPC (pour « Solid State Power Controller' » en anglais) et les contacteurs. Ils changent donc facilement d'état, ce qui peut modifier le fonctionnement ou endommager les autres composants électroniques.

Parmi les moyens d'isolation, les composants actifs de type transistor et thyristor sont particulièrement adaptés contre les foudroiements forts et lents, par exemple entre 70 et 120 µs.

Pour les foudroiements courts, il est avantageux d'utiliser des suppresseurs de surtensions.

Avantageusement, les perturbations atmosphériques comprennent le foudroiement et/ou une exposition à des rayons cosmiques et/ou ionisants.

L'invention a encore pour objet un aéronef comprenant un dispositif de prévention en temps réel de risque de perturbations atmosphériques tel que défini ci-dessus.

D'autres buts, caractéristiques et avantages de l'invention apparaîtront à la lecture de la description suivante, donnée uniquement à titre d'exemple non limitatif, et faite en référence aux dessins annexés sur lesquels :
[Fig 1] représente un groupe d'aéronefs, chacun comprenant un dispositif de prévention en temps réel de risques de perturbations atmosphériques et ;
[Fig 2] illustre les composants dudit dispositif de prévention.

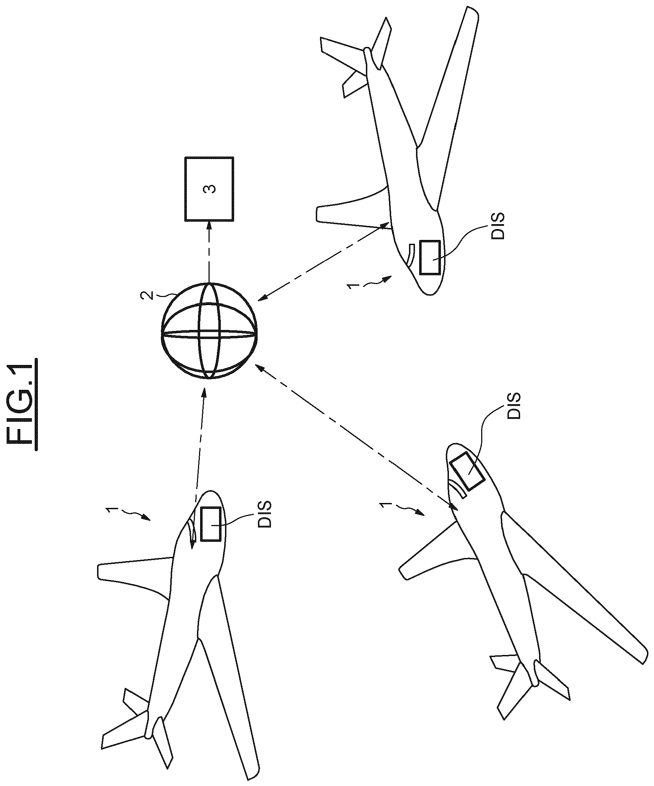

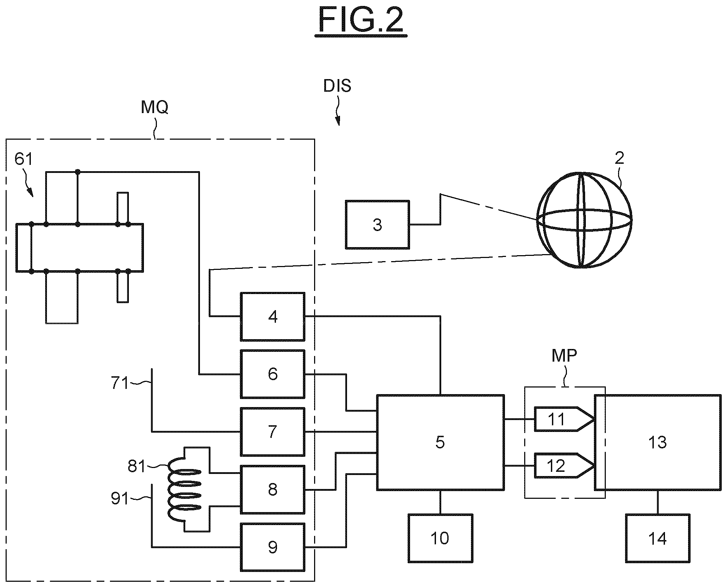

Sur la figure 1 est représenté un groupe d'aéronefs 1, chacun comprenant un dispositif de prévention en temps réel de risques de perturbations atmosphériques DIS dont les composants seront détaillés dans la figure 2;

Le dispositif de prévention DIS est apte à acquérir des données correspondant auxdits risques mais aussi à les transmettre à un autre aéronef 1 équipé dudit dispositif DIS, et cela afin d'élaborer une carte prédictive des risques.

La carte des risques sera visible sur un écran du poste de pilotage de l'aéronef 1.

Les données circulent entre deux aéronefs 1 via des nanosatellites ou par des constellations de satellites 2 aptes à défiler à orbite basse.

Les données peuvent en outre être stockées dans un serveur distant 3.

Par ailleurs, ce serveur distant 3 peut être consulté par tout aéronef 1 comprenant le dispositif DIS ou par toute station au sol ayant l'autorisation d'y accéder.

Ces données ainsi stockées constituent une base de données solide apte à prédire avec plus de précision les perturbations susceptibles d'être rencontrées sur un trajet aérien.

Ces données stockées seront par la suite corrélées avec des données mesurées par des moyens d'acquisition MQ à bord de l'aéronef 1 illustrés dans la figure 2.

Les moyens d'acquisition MQ sont aptes d'acquérir des données correspondant à au moins un risque.

Le dispositif de prévention DIS comprend ici un premier moyen de mesure 6 apte à mesurer le champs électrique et magnétique proche de l'aéronef 1.

Par « proche » on entend une distance entre 0 et 300m de l'aéronef en toute direction.

Le champ électrique permet de détecter un risque de foudroiement en champ proche, et le champ magnétique, par ses importantes variations, le passage ou le déclenchement d'une décharge de plusieurs centaines d'ampères par mètre.

Pour mesurer le champ électrique et le champ magnétique, le premier moyen de mesure 6 est ici couplé à deux fibres optiques 61 aptes à alimenter des capteurs électro-optiques non représentés ici.

Par ailleurs, il est à noter que lorsqu'on mesure le champ électrique, les capteurs électro-optiques effet Pockel sont alimentés.

Lorsque le champ magnétique est mesuré, ce sont les capteurs électro-optiques effet Faraday qui sont alimentés.

Les fibres optiques 61 sont en outre aptes à être fixées sur la façade de l'aéronef 1.

Pour une meilleure précision au niveau des mesures, il est avantageux de fixer les fibres optiques 61 sur les extrémités de l'avion par exemple à l'extrémité des ailes.

Afin de détecter les arcs électriques à longue distance, le dispositif de prévention DIS comprend en outre un deuxième moyen de mesure 7 apte à mesurer des ondes moyennes électriques radio ayant une fréquence entre 10 et 150 kHz.

Par ailleurs, le deuxième moyen de mesure 7 peut être couplé à une antenne fouet 71, particulièrement avantageuse pour la détection du champ électrique produit par les arcs électriques..

Un troisième moyen de mesure 8 permet de mesurer les ondes moyennes magnétiques radio issus des arcs électriques et ayant une fréquence entre 10 et 150 kHz afin de détecter à longue distance le passage ou le déclenchement d'une décharge. On peut par exemple le coupler à une antenne de type boucle 81.

En outre, afin d'exploiter au mieux les données mesurées, il est avantageux d'obtenir les positions exactes des perturbations atmosphériques détectées pour les placer sur la carte prédictive.

Pour ce faire, le dispositif de prévention DIS comprend des moyens de positionnement 9 aptes à acquérir des données relatives à la position de la perturbation détectée, notamment l'altitude, la latitude et l'heure de ladite détection, et cela via la constellation Galileo par exemple.

Ces données mesurées seront par la suite transmises à des moyens de conception 5 aptes à élaborer la carte prédictive en fonction de ces données.

Les moyens de conception 5 reçoivent également des données mesurées par d'autres aéronefs 1 comprenant ledit dispositif de prévention DIS, et cela en demandant dans un premier temps un accès au serveur distant 3 par des moyens de télécommunication 4.

A titre d'exemple, les moyens de télécommunication 4 peuvent être de type ADS-B (pour « Automatic dependent surveillance-broadcast » en anglais).

Ces données reçues, stockées initialement dans le serveur distant 3, comprennent une pluralité de grandeurs physiques, par exemple le champ électrique, le champ magnétique, les ondes électriques et magnétiques radio et les positions des différents aéronefs 1 en vol ou au sol lors de la détection d'un risque de perturbation.

Les moyens de conception 5 élaborent ensuite la carte prédictive en utilisant par exemple une machine d'apprentissage automatique supervisé ou non supervisé.

La machine d'apprentissage automatique permet définir plus précisément une zone critique correspondant à un niveau de risque déterminé, et cela pour chacun des risques de perturbations atmosphériques pour l'aéronef 1 en vol ou au sol.

Le traitement de ces données peut également être réalisé au sol et retransmis aux aéronefs 1. Cela permet également aux données recueillies d'être corrélées avec les informations au sol et ainsi augmenter la précision des mesures.

La carte prédictive élaborée sera affichée sur une planche de bord tout écran 10.

Le pilote de l'aéronef 1 peut ainsi prendre des dispositions d'évitement, de protection ou de désactivation de composants électroniques 14 susceptibles d'être endommagés lors de la traversée de l'aéronef 1 d'une zone critique par l'aéronef 1.

Pour ce faire, le dispositif de prévention DIS comprend des moyens de protection MP aptes à désactiver ou à programmer une désactivation ultérieure desdits composants électroniques 14.

Dans certains cas, une partie des composants électroniques sont essentiels au bon déroulement du trajet. Il est alors nécessaire d'isoler les composants par des moyens d'isolation non représentés dans la figure, afin de garantir leur fonctionnement optimal.

Il est à noter que la désactivation et l'isolation des composants électroniques se fait par l'utilisation de moyens de commande 11 et 12 aptes à déconnecter ou les couplages entre lesdits composants électroniques 14 et le système de distribution électrique 13 ou à les isoler.

Par ailleurs, l'invention n'est pas limitée à ces modes de réalisation et de mise en œuvre mais en embrasse toutes les variantes, par exemple on peut graduer le niveau de sensibilité des composants électroniques en fonction du niveau de risque.

## Revendications

1. Procédé de prévention en temps réel de risques de perturbations atmosphériques pour un aéronef (1) en vol ou au sol, comprenant au moins une acquisition par l'aéronef (1) de données correspondant auxdits risques, le procédé comprenant en outre une élaboration, à partir desdites données, d'une carte prédictive d'au moins une zone critique correspondant à au moins un niveau de risque de perturbation déterminé, et une mise en œuvre d'une protection de composants électroniques (14) à bord de l'aéronef (1) susceptibles d'être endommagés si ladite au moins une zone critique est traversée par l'aéronef (1), ladite au moins une acquisition comprend une mesure par l'aéronef (1) du champ électrique, du champ magnétique, des ondes électriques et magnétiques radio, et une réception à distance de données de mesure du champ électrique, du champ magnétique, des ondes électriques et des ondes magnétiques radio réalisés par au moins deux autres aéronefs en vol ou au sol et/ou des stations au sol.

2. Procédé selon la revendication 1, comprenant un stockage à distance (3) en temps réel des données acquises.

3. Procédé selon l'une des revendications 1 et 2, dans lequel l'élaboration de la carte prédictive comprend une mise en œuvre d'au moins une machine d'apprentissage automatique supervisé ou non supervisé.

4. Procédé selon l'une quelconque des revendications 1 à 3, dans lequel la mise en œuvre de la protection des composants électroniques (14) comprend une désactivation desdits composants (14) et/ou une activation de moyens d'isolation desdits composants (14).

5. Procédé selon l'une quelconque des revendications 1 à 4, dans lequel les perturbations atmosphériques comprennent le foudroiement et/ou une exposition à des rayons cosmiques et/ou ionisants.

6. Dispositif de prévention en temps réel de risques de perturbations atmosphériques (DIS) pour un aéronef (1) en vol ou au sol, comprenant des moyens d'acquisition (MQ) aptes à acquérir des données correspondant auxdits risques, le dispositif comprenant en outre des moyens de conception (5) aptes à élaborer une carte prédictive d'au moins une zone critique correspondant à au moins un niveau de risque de perturbation déterminé, et des moyens de protection (MP) de composants électroniques (14) à bord de l'aéronef (1) susceptibles d'être endommagés si ladite au moins une zone critique est traversée par l'aéronef (1), dans lequel les moyens d'acquisition (MQ) comprennent des moyens de mesure (6, 7, 8) aptes à mesurer le champ électrique, le champ magnétique, les ondes électriques et les ondes magnétiques radio, et des moyens de télécommunication (4) aptes à recevoir les données de mesure du champ électrique, du champ magnétique, et des ondes magnétiques et des ondes électriques radio, ces mesures étant réalisées par au moins deux autres aéronefs (1) en vol ou au sol et/ou des stations au sol.

7. Dispositif selon la revendication 6, dans lequel les moyens d'acquisition (MQ) comportent au moins un capteur électro-optique apte à mesurer le champ électrique et magnétique périphérique proche.

8. Dispositif selon l'une des revendications 6 et 7, comprenant des moyens de stockage à distance (3) en temps réel des données acquises.

9. Dispositif selon l'une quelconque des revendications 6 à 8, dans lequel les moyens de conception (5) comprennent au moins une machine d'apprentissage automatique supervisé ou non supervisé.

10. Dispositif selon l'une quelconque des revendications 6 à 9, dans lequel les moyens de protection (MP) comprennent des moyens d'isolation, les moyens de protection étant aptes à désactiver (11, 12) lesdits composants et/ou à activer (11, 12) les moyens d'isolation desdits composants.

11. Dispositif selon l'une quelconque des revendications 6 à 10, dans lequel les perturbations atmosphériques comprennent le foudroiement et/ou une exposition à des rayons cosmiques et/ou ionisants.

12. Aéronef (1) comprenant un dispositif de prévention en temps réel de risque de perturbations atmosphériques (DIS) selon l'une quelconque des revendications 6 à 11.

## Patentansprüche

1. Verfahren zur Echtzeit-Vermeidung von Risiken atmosphärischer Störungen für ein Luftfahrzeug (1) in dem Flug oder an dem Boden, umfassend mindestens eine Erfassung von Daten, die den Risiken entsprechen, durch das Luftfahrzeug (1), wobei das Verfahren ferner die Erstellung, anhand der Daten, einer prädiktiven Karte von mindestens einem kritischen Bereich, der mindestens einem bestimmten Störungsrisikoniveaus entspricht, und die Implementierung eines Schutzes elektronischer Komponenten (14) an Bord des Luftfahrzeugs (1) umfasst, die beschädigt werden können, wenn der mindestens eine kritische Bereich von dem Luftfahrzeug (1) durchquert wird, wobei die mindestens eine Erfassung eine Messung des elektrischen Felds, des Magnetfelds, der elektrischen Wellen und der magnetischen Funkwellen durch das Luftfahrzeug (1) und einen Fernempfang von Messdaten des elektrischen Felds, des Magnetfelds, der elektrischen Wellen und der magnetischen Funkwellen, die von mindestens zwei anderen Luftfahrzeugen in dem Flug oder an dem Boden und/oder von Bodenstationen erzielt wurden, umfasst.

2. Verfahren nach Anspruch 1, umfassend eine Fernspeicherung (3) in Echtzeit für die erfassten Daten.

3. Verfahren nach einem der Ansprüche 1 und 2, wobei die Erstellung der prädiktiven Karte eine Implementierung mindestens einer überwachten oder nicht überwachten Maschine für maschinelles Lernen umfasst.

4. Verfahren nach einem der Ansprüche 1 bis 3, wobei die Implementierung des Schutzes der elektronischen Komponenten (14) eine Deaktivierung der Komponenten (14) und/oder eine Aktivierung von Isolationsmitteln der Komponenten (14) umfasst.

5. Verfahren nach einem der Ansprüche 1 bis 4, wobei die atmosphärischen Störungen Blitzschlag und/oder Exposition gegenüber kosmischen und/oder ionisierenden Strahlen umfassen.

6. Vorrichtung zur Echtzeit-Vermeidung von Risiken atmosphärischer Störungen (DIS) für ein Luftfahrzeug (1) in dem Flug oder an dem Boden, umfassend Erfassungsmittel (MQ), die geeignet sind, Daten zu erfassen, die den Risiken entsprechen, wobei die Vorrichtung ferner Konstruktionsmittel (5), die geeignet sind, eine prädiktive Karte mindestens eines kritischen Bereichs zu erstellen, der mindestens einem bestimmten Störungsrisikoniveau entspricht, und Schutzmittel (MP) für elektronische Komponenten (14) an Bord des Luftfahrzeugs (1) umfasst, die beschädigt werden können, wenn der mindestens eine kritische Bereich von dem Luftfahrzeug (1) durchquert wird, wobei die Erfassungsmittel (MQ) Messmittel (6, 7, 8), die geeignet sind, das elektrische Feld, das Magnetfeld, die elektrischen Wellen und die magnetischen Funkwellen zu messen, sowie Telekommunikationsmittel (4) umfassen, die geeignet sind, die Messdaten des elektrischen Feldes, des Magnetfeldes, der magnetischen Wellen und der elektrischen Funkwellen zu empfangen, wobei diese Messungen von mindestens zwei anderen Luftfahrzeugen (1) in dem Flug oder an dem Boden und/oder von Bodenstationen durchgeführt werden.

7. Vorrichtung nach Anspruch 6, wobei die Erfassungsmittel (MQ) mindestens einen elektrooptischen Sensor umfassen, der geeignet ist, das elektrische und magnetische Feld in der nahen Umgebung zu messen.

8. Vorrichtung nach einem der Ansprüche 6 und 7, umfassend Fernspeichermittel (3) für die Echtzeit-Speicherung der erfassten Daten.

9. Vorrichtung nach einem der Ansprüche 6 bis 8, wobei die Konstruktionsmittel (5) mindestens eine überwachte oder nicht überwachte Maschine für maschinelles Lernen umfassen.

10. Vorrichtung nach einem der Ansprüche 6 bis 9, wobei die Schutzmittel (MP) Isolationsmittel umfassen, wobei die Schutzmittel geeignet sind, die Komponenten zu deaktivieren (11, 12) und/oder die Isolationsmittel der Komponenten zu aktivieren (11, 12).

11. Vorrichtung nach einem der Ansprüche 6 bis 10, wobei die atmosphärischen Störungen Blitzschlag und/oder Exposition gegenüber kosmischen und/oder ionisierenden Strahlen umfassen.

12. Luftfahrzeug (1), das eine Vorrichtung zur Echtzeit-Vermeidung von Risiken atmosphärischer Störungen (DIS) nach einem der Ansprüche 6 bis 11 umfasst.

## Claims

1. A method for preventing atmospheric disturbance risks in real time for an aircraft (1) in flight or on the ground, comprising at least one acquisition by the aircraft (1) of data corresponding to said risks, the method further comprising developing, from said data, a predictive map of at least one critical zone corresponding to at least one determined disturbance risk level, and implementing protection of electronic components (14) on board the aircraft (1) likely to be damaged if said at least one critical zone is traversed by the aircraft (1), said at least one acquisition comprises measurement by the aircraft (1) the electric field, magnetic field, radio electric and magnetic waves, and remotely receiving measurement data of the electric field, magnetic field, radio electric waves and magnetic waves performed by at least two other aircraft in flight or on the ground and/or ground stations.

2. The method according to claim 1, comprising remotely storing (3) in real time the data acquired.

3. The method according to one of claims 1 and 2, wherein developing the predictive map comprises implementing at least one supervised or unsupervised machine learning.

4. The method according to any one of claims 1 to 3, wherein implementing protection of the electronic components (14) comprises deactivating said components (14) and/or activating means for isolating said components (14).

5. The method according to any one of claims 1 to 4, wherein the atmospheric disturbances comprise lightning and/or exposure to cosmic and/or ionising rays.

6. A real-time atmospheric disturbance risk prevention device (DIS) for an aircraft (1) in flight or on the ground, comprising acquisition means (MQ) capable of acquiring data corresponding to said risks, the device further comprising design means (5) capable of developing a predictive map of at least one critical zone corresponding to at least one determined disturbance risk level, and protection means (MP) for electronic components (14) on board the aircraft (1) likely to be damaged if said at least one critical zone is traversed by the aircraft (1), wherein the acquisition means (MQ) comprise measuring means (6, 7, 8) capable of measuring the electric field, the magnetic field, radio electric waves and magnetic waves, and telecommunication means (4) capable of receiving the measurement data of the electric field, the magnetic field, and radio magnetic waves and electric waves, these measurements being carried out by at least two other aircraft (1) in flight or on the ground and/or ground stations.

7. The device according to claim 6, wherein the acquisition means (MQ) include at least one electro-optical sensor capable of measuring the near peripheral electric and magnetic field.

8. The device according to one of claims 6 and 7, comprising means for remotely storing (3) in real time the data acquired.

9. The device according to any one of claims 6 to 8, wherein the design means (5) comprise at least one supervised or unsupervised machine learning machine.

10. The device according to any one of claims 6 to 9, wherein the protection means (MP) comprise isolation means, the protection means being capable of deactivating (11, 12) said components and/or activating (11, 12) the isolation means of said components.

11. The device according to any one of claims 6 to 10, wherein the atmospheric disturbances comprise lightning and/or exposure to cosmic and/or ionising rays.

12. An aircraft (1) comprising a real-time atmospheric disturbance risk prevention device (DIS) according to any one of claims 6 to 11.
